# EUROPEAN PATENT APPLICATION

(11) **EP 4 685 264 A1**
(43) Date of publication of application: **28.01.2026**
(21) Application number: 25182750.7
(22) Date of filing: 13.06.2025
(51) Int. Cl.: C23C 16/02, C23C 16/04, C23C 16/455, H10P 10/00

(54) **PROCESSING METHOD, METHOD OF MANUFACTURING SEMICONDUCTOR DEVICE, PROCESSING APPARATUS, AND PROGRAM**

(30) Priority: 09.07.2024 JP 2024110406
(71) Applicant: Kokusai Electric Corporation, Tokyo 101-0045 (JP)
(72) Inventor: NAKATANI, Kimihiko, Toyama-shi, Toyama, 939-2393 (JP); MIYATA, Shoma, Toyama-shi, Toyama, 939-2393 (JP); HAMADA, Keitaro, Toyama-shi, Toyama, 939-2393 (JP)
(74) Representative: Bardehle Pagenberg Partnerschaft mbB Patentanwälte Rechtsanwälte

(57) **Abstract**

Provided is a technique which provides a substrate including a first surface and a second surface with an inhibitor adsorbed to the first surface and the second surface; and removes a part of the inhibitor adsorbed to the first surface and a part of the inhibitor adsorbed to the second surface by exposing the substrate to a processing agent to reduce or disable a film-formation inhibiting effect by the inhibitor remaining on the second surface while maintaining the film-formation inhibiting effect by the inhibitor remaining on the first surface

## Description

### Cross-Reference to Related Application

This application is based upon and claims the benefit of priority from Japanese Patent Application No. 2024-110406, filed on July 9, 2024, the entire contents of which are incorporated herein by reference.

### Field

The present disclosure relates to a processing method, a method of manufacturing a semiconductor device, a processing apparatus, and a program.

### Description of the Related Art

As a step of steps of manufacturing a semiconductor device, processing of allowing an inhibitor to adsorb to a specific surface among a plurality of surfaces on a surface of a substrate may be performed.

### Summary

Some embodiments of the present disclosure provide a technique capable of effectively adjusting a state of an inhibitor adsorbed to a surface of a substrate.

According to one embodiment of the present disclosure, provided is
(a) providing a substrate including a first surface and a second surface with an inhibitor adsorbed to the first surface and the second surface; and
(b) removing a part of the inhibitor adsorbed to the first surface and a part of the inhibitor adsorbed to the second surface by exposing the substrate to a processing agent to reduce or disable a film-formation inhibiting effect by the inhibitor remaining on the second surface while maintaining the film-formation inhibiting effect by the inhibitor remaining on the first surface.

### Brief Description of the Drawings

FIG. 1 is a schematic configuration diagram of a vertical processing furnace in a processing apparatus suitably used in one embodiment of the present disclosure, illustrating a longitudinal sectional view of a processing furnace 202 portion.
FIG. 2 is a schematic configuration diagram of the vertical processing furnace in the processing apparatus suitably used in one embodiment of the present disclosure, illustrating a cross-sectional view of the processing furnace 202 portion taken along line A-A of FIG. 1.
FIG. 3 is a schematic configuration diagram of a controller 121 of the processing apparatus suitably used in one embodiment of the present disclosure, illustrating a control system of a controller 121 in a block diagram.

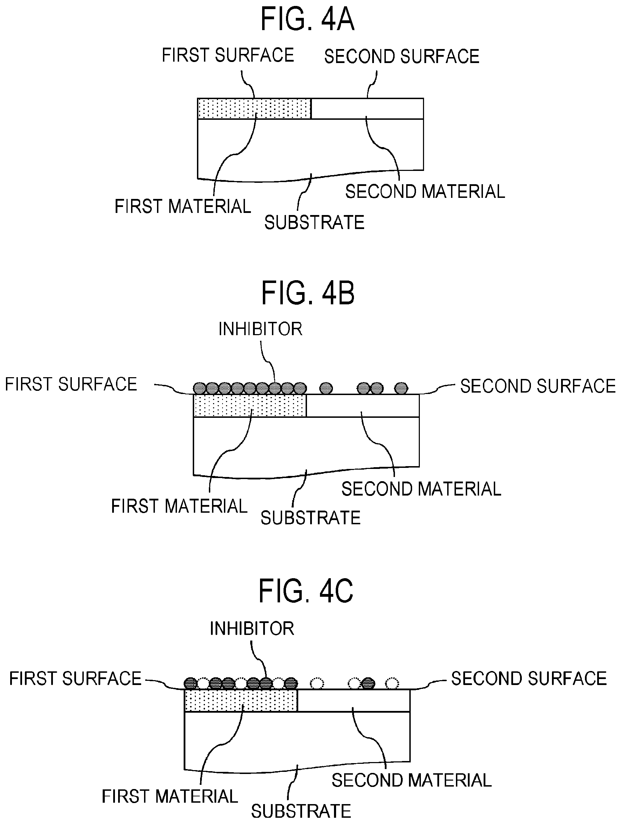

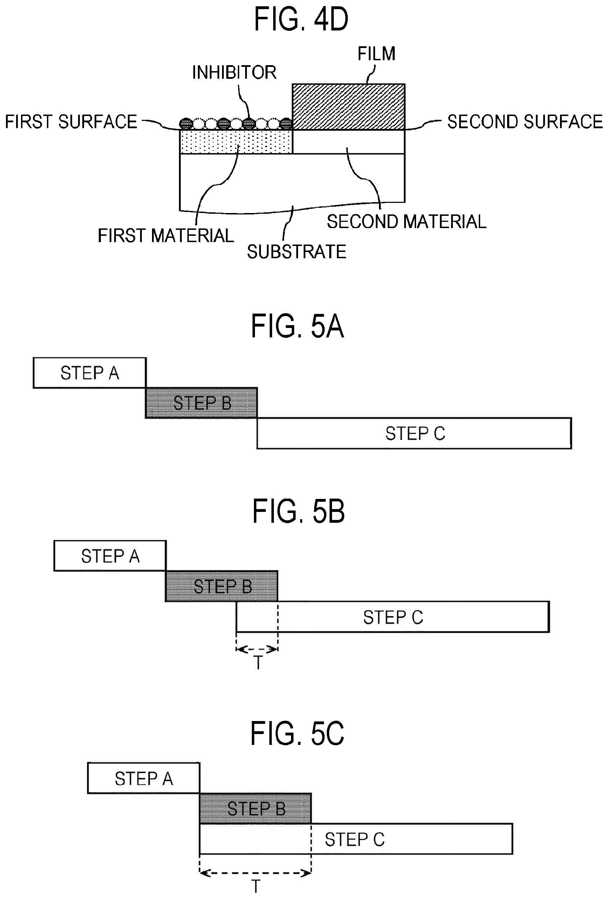

FIG. 4A is a partially enlarged cross-sectional view illustrating a surface portion of a substrate in one embodiment of the present disclosure including a first surface and a second surface. FIG. 4B is a partially enlarged cross-sectional view illustrating a surface portion of the substrate in one embodiment of the present disclosure after being exposed to a modifier from a state of FIG. 4A. FIG. 4C is a partially enlarged cross-sectional view illustrating the surface portion of the substrate in one embodiment of the present disclosure after being exposed to a processing agent from a state of FIG. 4B. FIG. 4D is a partially enlarged cross-sectional view illustrating the surface portion of the substrate in one embodiment of the present disclosure after being exposed to a film-forming agent from a state of FIG. 4C.
FIG. 5A is a sequence diagram of a processing method in one embodiment of the present disclosure in which steps A to C are sequentially performed without overlapping. FIG. 5B is a sequence diagram of a processing method in another embodiment of the present disclosure in which after step A is performed, step B is performed at least partially overlapping with step C. FIG. 5C is a sequence diagram of a processing method in another embodiment of the present disclosure in which after step A is performed, step B is performed so as to overlap with an initial stage of step C.

### Detailed Description

### <One Embodiment of Present Disclosure>

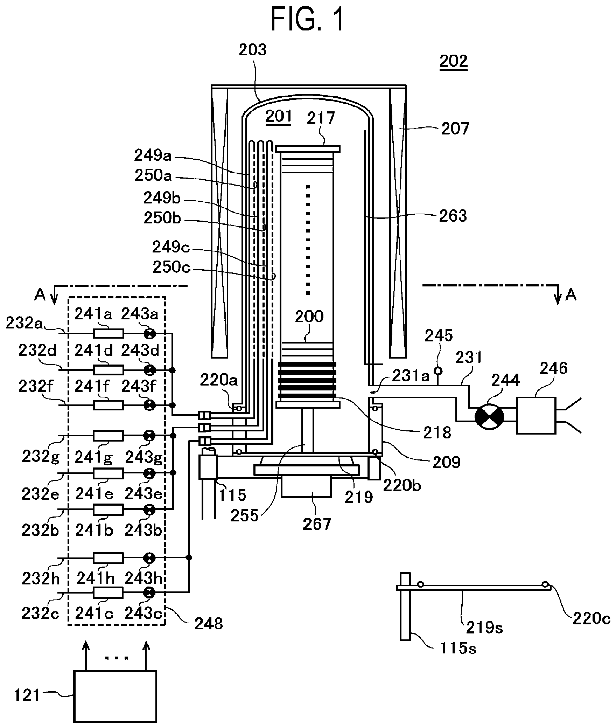

One embodiment of the present disclosure will be hereinafter described mainly with reference to FIGS. 1 to 3, FIGS. 4A to 4D, and FIG. 5A. The drawings used in the following description are all schematic, and a dimensional relationship between elements, a ratio between elements and the like illustrated in the drawings do not necessarily coincide with actual ones. Between a plurality of drawings, the dimensional relationship between the elements and the ratio between the elements do not necessarily coincide with each other.

### Configuration of Processing Apparatus

As illustrated in FIG. 1, a processing furnace 202 of a processing apparatus includes a heater 207 as a temperature regulator (heater). The heater 207 has a cylindrical shape and is supported by a holding plate to be vertically installed. The heater 207 also functions as an activating mechanism (exciter) that thermally activates (excites) a gas.

Inside the heater 207, a reaction tube 203 is arranged concentrically with the heater 207. The reaction tube 203 is made of, for example, a heat-resistant material such as quartz (SiO₂) or silicon carbide (SiC), and is formed into a cylindrical shape with an upper end closed and a lower end opened. A manifold 209 is arranged below the reaction tube 203 concentrically with the reaction tube 203. The manifold 209 is made of a metal material such as stainless steel (SUS), for example, into a cylindrical shape with an upper end and a lower end opened. An upper end portion of the manifold 209 engages with a lower end portion of the reaction tube 203 and is configured to support the reaction tube 203. An O-ring 220a as a seal member is provided between the manifold 209 and the reaction tube 203. The reaction tube 203 is vertically installed similarly to the heater 207. A processing container (reaction container) is formed mainly of the reaction tube 203 and the manifold 209. A processing chamber 201 is formed in a cylinder hollow portion of the processing container. The processing chamber 201 is configured to be able to accommodate a wafer 200 as a substrate. The wafer 200 is processed in the processing chamber 201.

In the processing chamber 201, nozzles 249a to 249c as first to third suppliers, respectively, are provided so as to penetrate a side wall of the manifold 209. The nozzles 249a to 249c are also referred to as first to third nozzles, respectively. The nozzles 249a to 249c are each made of, for example, a heat-resistant material such as quartz or SiC. Gas supply pipes 232a to 232c are connected to the nozzles 249a to 249c, respectively. The nozzles 249a to 249c are nozzles different from one another, and the nozzles 249a and 249c are provided adjacent to the nozzle 249b.

The gas supply pipes 232a to 232c are provided with mass flow controllers (MFCs) 241a to 241c as flow rate controllers (flow rate controllers), and valves 243a to 243c as opening/closing valves, respectively, in this order from an upstream side of a gas flow. Gas supply pipes 232d and 232f are connected to the gas supply pipe 232a on a downstream side of the valve 243a. Gas supply pipes 232e and 232g are connected to the gas supply pipe 232b on a downstream side of the valve 243b. A gas supply pipe 232h is connected to the gas supply pipe 232c on a downstream side of the valve 243c. The gas supply pipes 232d to 232h are provided with MFCs 241d to 241h and valves 243d to 243h, respectively, in this order from the upstream side of the gas flow. The gas supply pipes 232a to 232h are each made of, for example, a metal material such as SUS.

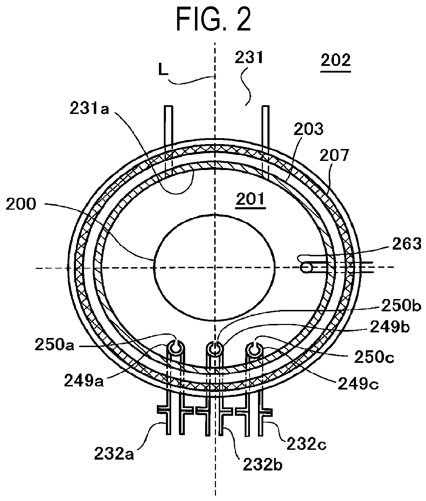

As illustrated in FIG. 2, the nozzles 249a to 249c are provided in an annular space in a plan view between an inner wall of the reaction tube 203 and the wafer 200 so as to extend upward in an arrangement direction of the wafers 200 along the inner wall of the reaction tube 203 from a lower portion to an upper portion. That is, the nozzles 249a to 249c are provided along a wafer arrangement region, in a region horizontally surrounding the wafer arrangement region lateral to the wafer arrangement region in which the wafers 200 are arranged. In a plan view, the nozzle 249b is arranged so as to be opposed to an exhaust port 231a to be described later on a straight line across the center of the wafer 200 in the processing chamber 201. The nozzles 249a and 249c are arranged so as to interpose a straight line L passing through the nozzle 249b and the center of the exhaust port 231a from both sides along the inner wall of the reaction tube 203 (outer peripheral portion of the wafer 200). The straight line L also passes through the nozzle 249b and the center of the wafer 200. That is, it can also be said that the nozzle 249c is provided on a side opposite to the nozzle 249a across the straight line L. The nozzles 249a and 249c are arranged in line symmetry with the straight line L as a symmetry axis. On side surfaces of the nozzles 249a to 249c, gas supply holes 250a to 250c through which a gas is supplied are formed, respectively. The gas supply holes 250a to 250c are each opened so as to be opposed to (face) the exhaust port 231a in a plan view, and can supply the gas toward the wafer 200. A plurality of gas supply holes 250a to 250c is formed from the lower portion to the upper portion of the reaction tube 203.

A modifier is supplied from the gas supply pipe 232a into the processing chamber 201 via the MFC 241a, the valve 243a, and the nozzle 249a.

A source is supplied from the gas supply pipe 232b into the processing chamber 201 via the MFC 241b, the valve 243b, and the nozzle 249b. The source is used as one of a film-forming agents.

A reactant is supplied from the gas supply pipe 232c into the processing chamber 201 via the MFC 241c, the valve 243c, and the nozzle 249c. The reactant is used as one of the film-forming agents.

A catalyst is supplied from the gas supply pipe 232d into the processing chamber 201 via the MFC 241d, the valve 243d, the gas supply pipe 232a, and the nozzle 249a. The catalyst is used as one of the film-forming agents.

A processing agent is supplied from the gas supply pipe 232e into the processing chamber 201 via the MFC 241e, the valve 243e, the gas supply pipe 232b, and the nozzle 249b.

An inert gas is supplied from the gas supply pipes 232f to 232h into the processing chamber 201 via the MFCs 241f to 241h, the valves 243f to 243h, the gas supply pipes 232a to 232c, and the nozzles 249a to 249c, respectively. The inert gas acts as a purge gas, a carrier gas, a diluent gas and the like.

A modifier supply system (modifier exposure system) is formed mainly of the gas supply pipe 232a, the MFC 241a, and the valve 243a. A source supply system (source exposure system) is formed mainly of the gas supply pipe 232b, the MFC 241b, and the valve 243b. A reactant supply system (reactant exposure system) is formed mainly of the gas supply pipe 232c, the MFC 241c, and the valve 243c. A catalyst supply system (catalyst exposure system) is formed mainly of the gas supply pipe 232d, the MFC 241d, and the valve 243d. A processing agent supply system (processing agent exposure system) is formed mainly of the gas supply pipe 232e, the MFC 241e, and the valve 243e. An inert gas supply system (inert gas exposure system) is formed mainly of the gas supply pipes 232f to 232h, the MFCs 241f to 241h, and the valves 243f to 243h. Each or all of the source supply system, the reactant supply system, and the catalyst supply system is/are also referred to as a film-forming agent supply system (film-forming agent exposure system).

Any one or all of the various supply systems described above may be formed as an integrated supply system 248 in which the valves 243a to 243h, the MFCs 241a to 241h and the like are integrated. The integrated supply system 248 is connected to each of the gas supply pipes 232a to 232h, and is configured such that a supplying operation of various substances (various gases) into the gas supply pipes 232a to 232h, that is, an opening/closing operation of the valves 243a to 243h, a flow rate regulating operation by the MFCs 241a to 241h and the like are controlled by a controller 121 to be described later. The integrated supply system 248 is formed as an integral or separable integrated unit, and can be attached to or detached from the gas supply pipes 232a to 232h and the like on an integrated unit basis, so that the integrated supply system 248 can be maintained, replaced, added and the like on an integrated unit basis.

The exhaust port 231a from which an atmosphere inside the processing chamber 201 is discharged is formed in a lower portion of a side wall of the reaction tube 203. As illustrated in FIG. 2, the exhaust port 231a is provided at a position opposed to (facing) the nozzles 249a to 249c (gas supply holes 250a to 250c) across the wafer 200 in a plan view. The exhaust port 231a may be provided along the side wall of the reaction tube 203 from the lower portion toward the upper portion, that is, along the wafer arrangement region. An exhaust pipe 231 is connected to the exhaust port 231a. A vacuum pump 246 as a vacuum exhaust device is connected to the exhaust pipe 231 via a pressure sensor 245 as a pressure detector (pressure detector) that detects a pressure in the processing chamber 201 and an auto pressure controller (APC) valve 244 as a pressure regulator (pressure regulator). The APC valve 244 is configured to be able to vacuum-exhaust the processing chamber 201 and stop the vacuum-exhaust by opening and closing a valve thereof in a state in which the vacuum pump 246 is operating, and further regulate the pressure in the processing chamber 201 by adjusting a degree of valve opening on the basis of pressure information detected by the pressure sensor 245 in a state in which the vacuum pump 246 is operating. An exhaust system is formed mainly of the exhaust pipe 231, the APC valve 244, and the pressure sensor 245. The vacuum pump 246 may be included in the exhaust system.

A seal cap 219 as a furnace opening lid capable of hermetically closing the lower end opening of the manifold 209 is provided below the manifold 209. The seal cap 219 is made of, for example, a metal material such as SUS into a disk shape. An O-ring 220b as a seal member that abuts the lower end of the manifold 209 is provided on an upper surface of the seal cap 219. A rotating mechanism 267 that rotates a boat 217 to be described later is arranged below the seal cap 219. A rotating shaft 255 of the rotating mechanism 267 penetrates the seal cap 219 and is connected to the boat 217. The rotating mechanism 267 is configured to rotate the boat 217, thereby rotating the wafer 200. A boat elevator 115 as a lifting mechanism provided outside the reaction tube 203 is configured to vertically lift the seal cap 219. The boat elevator 115 is configured as a transfer device (transfer mechanism) that lifts the seal cap 219, thereby loading and unloading (transferring) the wafer 200 into/from the processing chamber 201, and functions as a device (provider) that provides the wafer 200 in the processing chamber 201. **In** a case where adsorption of an inhibitor to the surface of the wafer 200 is performed in the processing chamber 201 as in the present embodiment, each unit (modifier supply system, heater, exhaust system and the like) of the processing apparatus used for the processing may be included in the provider.

Below the manifold 209, a shutter 219s as a furnace opening lid capable of hermetically closing the lower end opening of the manifold 209 in a state in which the seal cap 219 is lowered and the boat 217 is unloaded from the inside of the processing chamber 201 is provided. The shutter 219s is made of, for example, a metal material such as SUS into a disk shape. An O-ring 220c as a seal member that abuts the lower end of the manifold 209 is provided on an upper surface of the shutter 219s. An opening/closing operation (lifting operation, rotating operation and the like) of the shutter 219s is controlled by a shutter opening/closing mechanism 115s.

The boat 217 as a substrate support is configured to support a plurality of, for example, 25 to 200 wafers 200 horizontally, in multiple stages so as to be aligned vertically with the centers aligned with one another, that is, to arrange the wafers 200 at intervals. The boat 217 is made of, for example, a heat-resistant material such as quartz and SiC. Heat insulating plates 218 each made of, for example, a heat-resistant material such as quartz or SiC are supported in multiple stages in a lower portion of the boat 217.

A temperature sensor 263 as a temperature detector is provided in the reaction tube 203. By regulating a degree of energization to the heater 207 on the basis of temperature information detected by the temperature sensor 263, a desired temperature distribution can be achieved in the processing chamber 201. The temperature sensor 263 is provided along the inner wall of the reaction tube 203.

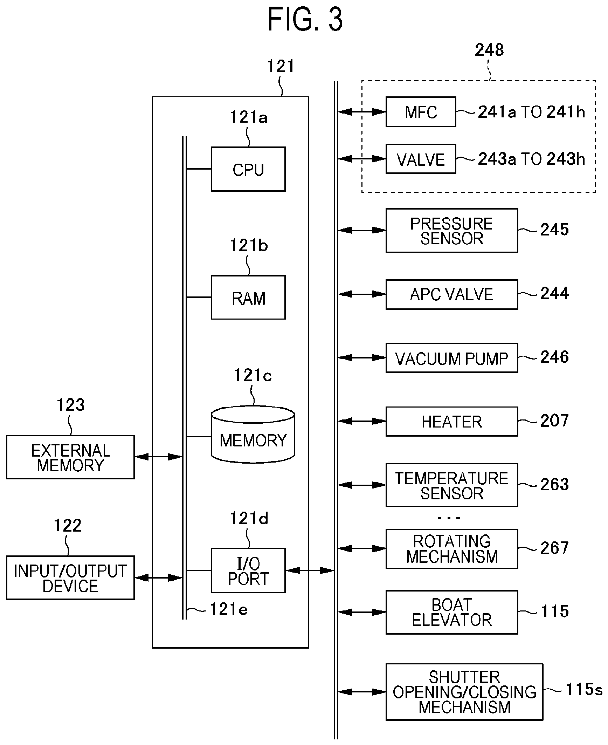

As illustrated in FIG. 3, a controller 121 as a controller (controlling mechanism) is configured as a computer including a central processing unit (CPU) 121a, a random access memory (RAM) 121b, a memory 121c, and an I/O port 121d. The RAM 121b, the memory 121c, and the I/O port 121d are configured to be able to exchange data with the CPU 121a via an internal bus 121e. An input/output device 122 configured as, for example, a touch panel and the like is connected to the controller 121. An external memory 123 can be connected to the controller 121. The processing apparatus may be provided with one controller or a plurality of controllers. That is, control for performing a processing sequence to be described later may be performed using one controller or a plurality of controllers. A plurality of controllers may be configured as a control system mutually connected by a wired or wireless communication network, and control for performing the processing sequence to be described later may be performed by an entire control system. In a case where the term "controller" is used in this specification, this might include a case where a plurality of controllers is included and a case where a control system constituted by a plurality of controllers is included in addition to a case where one controller is included.

The memory 121c includes, for example, a flash memory, a hard disk drive (HDD), a solid state drive (SSD) and the like. In the memory 121c, a control program that controls an operation of the processing apparatus, a process recipe in which procedures, conditions and the like of substrate processing to be described later are described and the like are readably recorded and stored. The process recipe is a combination that allows the controller 121 to allow the processing apparatus to execute each procedure in the substrate processing to be described later (film-forming processing and the like) to obtain a predetermined result, and functions as a program. Hereinafter, the process recipe, the control program and the like are collectively and simply referred to as a program (program product). The process recipe is simply referred to as a recipe. In a case where the term "program" is used in the present specification, this might include the recipe alone, the control program alone, or both of them. The RAM 121b is configured as a memory area (work area) in which programs, data and the like read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotating mechanism 267, the boat elevator 115, the shutter opening/closing mechanism 115s and the like described above.

The CPU 121a is configured to be able to read the control program from the memory 121c and execute the same, and read the recipe from the memory 121c in response to an input and the like of an operation command from the input/output device 122. The CPU 121a is configured to be able to control, in accordance with a content of the read recipe, a flow rate regulating operation of various substances (various gases) by the MFCs 241a to 241h, an opening/closing operation of the valves 243a to 243h, a pressure regulating operation by the APC valve 244 based on an opening/closing operation of the APC valve 244 and the pressure sensor 245, start and stop of the vacuum pump 246, a temperature regulating operation of the heater 207 based on the temperature sensor 263, rotation and rotating speed regulating operation of the boat 217 by the rotating mechanism 267, a lifting operation of the boat 217 by the boat elevator 115, an opening/closing operation of the shutter 219s by the shutter opening/closing mechanism 115s and the like.

The controller 121 can be configured by installing the above-described program recorded and stored in the external memory 123 into the computer. Examples of the external memory 123 include, for example, a magnetic disk such as a HDD, an optical disk such as a CD, a semiconductor memory such as a USB memory, a SSD and the like. The memory 121c and the external memory 123 are configured as computer-readable recording media. Hereinafter, they are collectively and simply referred to as recording media. In a case where the term "recording medium" is used in this specification, this might include a case where the memory 121c alone is included, a case where the external memory 123 alone is included, or a case where both of them are included. The program may be provided to the computer by using a communication means such as the Internet and a dedicated line without using the external memory 123.

### (2) Processing Step

As a step of steps of manufacturing (a manufacturing method of) a semiconductor device using the processing apparatus described above, an example of a method of processing a substrate (processing method), that is, a processing sequence for adjusting a state of the inhibitor adsorbed to the surface of the wafer 200 as the substrate and thereafter forming a film on a part of the surface of the wafer 200 will be described mainly with reference to FIGS. 4A to 4D and 5A. In the following description, the controller 121 controls the operation of each unit forming the processing apparatus. The processing apparatus is also referred to as a substrate processing apparatus, a film-forming processing apparatus, or a film-forming apparatus. The processing method is also referred to as a substrate processing method, a film-forming processing method, or a film-forming method.

In the processing sequence in the present embodiment,
(a) step A of providing a wafer 200 including a first surface and a second surface with an inhibitor adsorbed to the first surface and the second surface; and
(b) step B of removing a part of the inhibitor adsorbed to the first surface and a part of the inhibitor adsorbed to the second surface by exposing the wafer 200 to a processing agent to reduce or disable a film-formation inhibiting effect by the inhibitor remaining on the second surface while maintaining the film-formation inhibiting effect by the inhibitor remaining on the first surface are performed.

In the following example,
a case of further performing (c) step C of forming a film on the second surface by exposing the wafer 200, which has been exposed to the processing agent, to a film-forming agent will be described.

In the following example, as illustrated in FIG. 5A,
a case of performing steps A to C in this order without overlapping will be described.

The term "wafer" used in this specification might mean the wafer itself, or a laminate of the wafer and a predetermined layer or film formed on a surface thereof. The term "surface of the wafer" used in this specification might mean the surface of the wafer itself or a surface of a predetermined layer and the like formed on the wafer. The expression "forming a predetermined layer on the surface of the wafer" in this specification might mean that a predetermined layer is directly formed on the surface of the wafer itself or that a predetermined layer is formed on the layer and the like formed on the wafer. In a case where the term "substrate" is used in this specification, this is a synonym of the term "wafer."

The term "agent" and "substance" used in this specification includes at least one selected from the group of a gaseous substance and a liquid substance. The liquid substance includes a mist substance. That is, each of the modifier, the processing agent, the film-forming agent (source, reactant, and catalyst) may each contain the gaseous substance, the liquid substance such as the mist substance, or both of them.

### (Wafer Charge and Boat Load)

When a plurality of wafers 200 is loaded on the boat 217 (wafer charge), the shutter opening/closing mechanism 115s moves the shutter 219s, and the lower end opening of the manifold 209 is opened (shutter open). Thereafter, as illustrated in FIG. 1, the boat 217 that supports the plurality of wafers 200 is raised by the boat elevator 115 and is loaded into the processing chamber 201 (boat load). In this state, the lower end of the manifold 209 is sealed with the seal cap 219 via the O-ring 220b.

As illustrated in FIG. 4A, the wafer 200 as the substrate loaded on the boat 217 includes a first material and a second material on the surface thereof. A surface of the first material forms the first surface, and a surface of the second material forms the second surface. The first material and the second material are also referred to as a first base and a second base, respectively.

Here, the first surface contains an oxide, and the second surface contains a material different from the oxide (the oxide contained in the first surface). Oxygen concentration of the first surface is higher than oxygen concentration of the second surface. That is, density of hydroxyl groups (OH groups) terminating at the first surface is higher than density of OH groups terminating at the second surface.

The first surface might contain silicon (Si) and the second surface might contain at least one selected from the group of Si and metal, or be Si-free. The first surface might contain Si and oxygen (O), and the second surface might contain Si and nitrogen (N). As exemplified below, each of the first surface and the second surface can be made of any material as long as the above-described condition that the oxygen concentration of the first surface is higher than the oxygen concentration of the second surface, that is, the density of OH groups terminating at the first surface is higher than the density of OH groups terminating at the second surface is satisfied.

The first surface might be made of a material containing Si and O, such as silicon oxide (SiO), silicon oxynitride (SiON), silicon oxycarbide (SiOC), silicon oxycarbonitride (SiOCN), silicon boron oxynitride (SiBON), or silicon boron oxycarbonitride (SiBCON), for example. The first surface might be made of a material containing metal, Si, and O such as aluminum silicon oxide (AlSiO), titanium silicon oxide (TiSiO), zirconium silicon oxide (ZrSiO), hafnium silicon oxide (HfSiO), or tantalum silicon oxide (TaSiO), for example. The first surface might be made of a material containing metal and O, such as aluminum oxide (AlO), titanium oxide (TiO), zirconium oxide (ZrO), hafnium oxide (HfO), tantalum oxide (TaO), molybdenum oxide (MoO), zirconium aluminum oxide (ZrAlO), or hafnium aluminum oxide (HfAlO), for example. These materials can also be referred to as films, and for example, oxides can also be referred to as oxide films.

The second surface might be made of a material having the same element as the above-described material forming the first surface and having the oxygen concentration lower than that of the material forming the first surface, for example. The second surface might be made of a material containing Si and N, such as silicon nitride (SiN), silicon carbonitride (SiCN), silicon boron nitride (SiBN), or silicon boron carbonitride (SiBCN), for example. The second surface might be made of a material containing metal and N, such as aluminum nitride (AlN), titan nitride (TiN), or tungsten nitride (WN), for example. The second surface might be made of a material containing a semiconductor element or a metal element, such as silicon (Si), silicon germanium (SiGe), tungsten (W), or molybdenum (Mo), for example. These materials can also be referred to as films, and for example, nitrides can also be referred to as nitride films.

### (Pressure Regulation and Temperature Regulation)

After the boat load is finished, the inside of the processing chamber 201, that is, a space in which the wafer 200 is present is vacuum-exhausted (decompression-exhausted) by the vacuum pump 246 so as to achieve a desired pressure (vacuum degree). At that time, the pressure in the processing chamber 201 is measured by the pressure sensor 245, and the APC valve 244 is feedback-controlled on the basis of information of the measured pressure. The heater 207 heats in such a manner that temperature of the wafer 200 in the processing chamber 201 reaches desired processing temperature. At that time, on the basis of the temperature information detected by the temperature sensor 263, the degree of energization to the heater 207 is feedback-controlled in such a manner that the desired temperature distribution is obtained in the processing chamber 201. The rotating mechanism 267 starts to rotate the wafer 200. Both the exhaust in the processing chamber 201, the heating and rotation of the wafer 200 continue at least until the processing on the wafer 200 is finished.

### (Step A)

Thereafter, the wafer 200 is exposed to the modifier.

Specifically, the valve 243a is opened to allow the modifier to flow through the gas supply pipe 232a. The modifier, a flow rate of which is regulated by the MFC 241a, is supplied into the processing chamber 201 via the nozzle 249a, and discharged from the exhaust port 231a. At that time, the modifier is supplied from a lateral side of the wafer 200 to the wafer 200, and the wafer 200 is exposed to the modifier (modifier supply, exposure). At that time, the valves 243f to 243h may be opened to supply the inert gas into the processing chamber 201 via the nozzles 249a to 249c, respectively.

By exposing the wafer 200 to the modifier under processing conditions to be described later, as illustrated in FIG. 4B, at least a part of a molecular structure of molecules forming the modifier, that is, the inhibitor contained in the modifier can be adsorbed to the first surface and the second surface. The inhibitor adsorbed to the surface of the wafer 200 functions to inhibit (suppress) progress of a film-forming reaction on the surface of the wafer 200, that is, to prolong an incubation time at step C to be described later. This effect by the inhibitor is also referred to as the film-formation inhibiting effect (reaction suppressing effect, inhibitor effect).

This step is preferably performed under at least one selected from the group of the following conditions: a condition that an amount of the inhibitor to be adsorbed to the first surface is larger than an amount of the inhibitor to be adsorbed to the second surface, a condition that density of the inhibitor to be adsorbed to the first surface is higher than density of the inhibitor to be adsorbed to the second surface, and a condition that coverage of the first surface by the inhibitor to be adsorbed to the first surface is higher than coverage of the second surface by the inhibitor to be adsorbed to the second surface.

This step is preferably performed under the condition that a continuous layer is formed by the inhibitor to be adsorbed to the first surface and a discontinuous layer is formed by the inhibitor to be adsorbed to the second surface. The layer formed by the inhibitor adsorbed to the surface of the wafer 200 is also referred to as an inhibitor layer.

After the inhibitor is adsorbed to the first surface and the second surface, the valve 243a is closed to stop supplying the modifier into the processing chamber 201. The inside of the processing chamber 201 is vacuum-exhausted to remove the gaseous substance and the like remaining in the processing chamber 201 from the inside of the processing chamber 201. At that time, the valves 243f to 243h are opened to supply the inert gas into the processing chamber 201 via the nozzles 249a to 249c. The inert gas supplied from the nozzles 249a to 249c acts as a purge gas, and accordingly, the inside of the processing chamber 201 is purged (purge). Processing temperature when purging at this step is preferably similar to processing temperature when supplying the modifier.

In this manner, the wafer 200 including the first surface and the second surface with the inhibitor adsorbed to the first surface and the second surface is provided in the processing chamber 201.

The processing conditions when supplying the modifier at step A are exemplified as follows:
processing temperature: room temperature (25 degrees C) to 500 degrees C, preferably 25 to 250 degrees C,
processing pressure: 5 to 2,000 Pa, preferably 10 to 1,000 Pa,
processing time: 1 second to 120 minutes, preferably 30 seconds to 60 minutes,
modifier supply flow rate: 0.001 to 3 slm, preferably 0.001 to 0.5 slm, and
inert gas supply flow rate (per gas supply pipe): 0 to 20 slm.

In this specification, an expression of a numerical range such as "25 to 500 degrees C" means that a lower limit value and an upper limit value are included in the range. Therefore, for example, "25 to 500 degrees C" means "equal to or higher than 25 degrees C and equal to lower than 500 degrees C." The same applies to other numerical ranges. In this specification, the processing temperature means the temperature of the wafer 200 or the temperature in the processing chamber 201, and the processing pressure means the pressure in the processing chamber 201. The processing time means a time in which the processing is continued. In a case where 0 slm is included in the supply flow rate, 0 slm means a case where the substance (gas) is not supplied. The same applies to the following description.

As the modifier, for example, a substance containing at least one selected from the group of a hydrocarbon group and an amino group and/or a fluorine (F)-containing substance can be used. In a case where both substances are used, it is preferable that a substance containing at least one selected from the group of a hydrocarbon group and an amino group is first supplied, and then the F-containing substance is supplied after purge. In a case where a substance exemplified below is used, the first surface and the second surface are terminated with a hydrocarbon group such as an alkyl group, hydrogen (H), or F, and a hydrocarbon group termination such as an alkyl group termination, a H termination, a F termination and the like functions as an inhibitor.

As the modifier, for example, a substance in which hydrogen (H) and an amino group bond to Si, that is, aminosilane such as a tetrakis(dimethylamino)silane (Si[N(CH₃)₂]₄), tris(dimethylamino)silane (Si[N(CH₃)₂]₃H), bis(diethylamino)silane (Si[N(C₂H₅)₂]₂H₂), bis(tertiary butylamino)silane (SiH₂[NH(C₄H₉)]₂), (diisobutylamino)silane (SiH₃[N(C₄H₉)₂]), and (diisopropylamino)silane (SiH₃[N(C₃H₇)₂]) can be used.

As the modifier, for example, a substance in which an amino group and an alkyl group bond to Si, that is, alkylaminosilane such as (dimethylamino)trimethylsilane ((CH₃)₂NSi(CH₃)₃), (diethylamino)triethylsilane ((C₂H₅)₂NSi(C₂H₅)₃), (dimethylamino)triethylsilane ((CH₃)₂NSi(C₂H₅)₃), (diethylamino)trimethylsilane ((C₂H₅)₂NSi(CH₃)₃), and (dipropylamino)trimethylsilane ((C₃H₇)₂NSi(CH₃)₃) can be used.

As the modifier, for example, it is possible to use fluorine (F₂), nitrogen trifluoride (NF₃), chlorine trifluoride (ClF₃), chlorine fluoride (ClF), hydrogen fluoride (HF) and the like.

One or more of them may be used as the modifier.

As the inert gas, a nitrogen (N₂) gas or a rare gas such as an argon (Ar) gas, a helium (He) gas, a neon (Ne) gas, or a xenon (Xe) gas can be used. One or more of these gases can be used as the inert gas. The same applies to each step to be described later.

### (Step B)

After step A is finished, the wafer 200 is exposed to a processing agent.

Specifically, the valve 243e is opened to allow the processing agent to flow through the gas supply pipe 232e. The processing agent, a flow rate of which is regulated by the MFC 241e, is supplied into the processing chamber 201 via the nozzle 249b and discharged from the exhaust port 231a. At that time, the processing agent is supplied from the lateral side of the wafer 200 to the wafer 200, and the wafer 200 is exposed to the processing agent (processing agent supply, exposure). At that time, the valves 243f to 243h may be opened to supply the inert gas into the processing chamber 201 via the nozzles 249a to 249c, respectively.

By exposing the wafer 200 to the processing agent under the processing conditions to be described later, as illustrated in FIG. 4C, a part of the inhibitor adsorbed to the first surface and a part of the inhibitor adsorbed to the second surface can be removed. A broken line in FIG. 4C schematically indicates that the inhibitor has been removed. FIG. 4C illustrates an example in which an amount by which the inhibitor adsorbed to the first surface is removed is equivalent to an amount by which the inhibitor adsorbed to the second surface is removed, that is, an example in which a part of the inhibitor is non-selectively removed from each of the first surface and the second surface. This non-selective removal makes it possible to reduce or disable the film-formation inhibiting effect by the inhibitor remaining on the second surface while maintaining the film-formation inhibiting effect by the inhibitor remaining on the first surface. In FIG. 4C, the amount of the inhibitor remaining on the second surface is much smaller than the amount of the inhibitor remaining on the first surface. Therefore, at a glance, the inhibitor adsorbed to the second surface appears to be selectively removed, but since the amount of the inhibitor removed from the second surface is not larger than the amount of the inhibitor removed from the first surface, this does not correspond to selective removal, and corresponds to the non-selective removal.

At this step, the amount by which the inhibitor adsorbed to the first surface is removed is preferably equal to or more than the amount by which the inhibitor adsorbed to the second surface is removed, and more preferably, more than the amount by which the inhibitor adsorbed to the second surface is removed.

After the inhibitor is partially removed from each of the first surface and the second surface, the valve 243e is closed to stop supplying the processing agent into the processing chamber 201. By the processing procedure and processing conditions similar to those in the purge at step A, the gaseous substance and the like remaining in the processing chamber 201 is removed from the inside of the processing chamber 201 (purge). The processing temperature when purging at this step is preferably similar to the processing temperature when supplying the processing agent.

Processing conditions when supplying the processing agent at step B are exemplified as follows:
processing temperature: room temperature (25 degrees C) to 600 degrees C, preferably 50 to 400 degrees C,
processing pressure: 1 to 105, 000 Pa, preferably 10 to 10,000 Pa,
processing time: 1 to 10,000 seconds, preferably 5 to 3,600 seconds,
processing agent supply flow rate: 0.01 to 10 slm, preferably 0.1 to 5 slm, and
inert gas supply flow rate (per gas supply pipe): 0 to 20 slm.

As the processing agent, for example, a nitrogen (N)-containing substance, a hydrogen (H)-containing substance, an oxygen (O)-containing substance, a fluorine (F)-containing substance, a chlorine (Cl)-containing substance and the like can be used. As the processing agent, for example, a N and H-containing substance, a H and O-containing substance, a H and F-containing substance, a N and F-containing substance, a Cl and F-containing substance, a F, N and O-containing substance, a H and Cl-containing substance, a Cl and Si-containing substance and the like can be used. A catalyst that can be used at step C to be described later may be added to the processing agent. The addition of the catalyst makes it possible to promote the action as the processing agent of the H and O-containing substance and the like.

As the N and H-containing substance, hydrogen nitride such as ammonia (NH₃), hydrazine (N₂H₄), or diazene (N₂H₂) can be used, for example. As the H and O-containing substance, for example, water (H₂O), hydrogen peroxide (H₂O₂) and the like can be used. As the O-containing gas, for example, oxygen (O₂), ozone (O₃) and the like can be used. As the H and F-containing substance, for example, hydrogen fluoride (HF) and the like can be used. As the F-containing substance, for example, fluorine (F₂) and the like can be used. As the N and F-containing substance, for example, nitrogen trifluoride (NF₃) and the like can be used. As the Cl and F-containing substance, for example, chlorine trifluoride (ClF₃), chlorine fluoride (ClF) and the like can be used. As the F, N, and O-containing substance, for example, nitrosyl fluoride (FNO) and the like can be used. As the H and Cl-containing substance, for example, hydrogen chloride (HCl) and the like can be used. As the Cl-containing substance, for example, chlorine (Cl₂) and the like can be used. As the Cl and Si-containing substance, for example, hexachlorodisilane (Si₂Cl₆), tetrachlorosilane (SiCl₄), trichlorosilane (SiHCl₃), dichlorosilane (SiH₂Cl₂), monochlorosilane (SiH₃Cl), bis(trichlorosilyl)methane ((SiCl₃)₂CH₂), 1,2-bis(trichlorosilyl)ethane ((SiCl₃)₂C₂H₄), hexachlorodisiloxane (Cl₃Si-O-SiCl₃), octachlorotrisiloxane (Cl₃Si-O-SiCl₂-O-SiCl₃) and the like can be used.

One or more of them can be used as the processing agent.

### (Step C)

After step B is finished, the following steps C1 and C2 are performed to expose the wafer 200 to the film-forming agent.

### [Step C1]

At this step, the wafer 200 is exposed to a source as a film-forming agent.

Specifically, the valve 243b is opened to allow the source to flow through the gas supply pipe 232b. The source, a flow rate of which is regulated by the MFC 241b, is supplied into the processing chamber 201 via the nozzle 249b, mixed in the processing chamber 201, and discharged from the exhaust port 231a. At that time, the source is supplied from the lateral side of the wafer 200 to the wafer 200, and the wafer 200 is exposed to the source (source supply, exposure). At that time, the valve 243d may be opened to cause the catalyst to flow through the gas supply pipe 232d, supply the wafer 200 with the source and the catalyst, and expose the wafer 200 to the source and the catalyst. At that time, the valves 243f to 243h may be opened to supply the inert gas into the processing chamber 201 via the nozzles 249a to 249c, respectively.

By exposing the wafer 200 to the source under the processing conditions to be described later, it is possible to allow at least a part of the molecular structure of the molecules forming the source to be selectively adsorbed to the second surface while suppressing adsorption of at least a part of the molecular structure of the molecules forming the source to the first surface. As a result, the first layer is selectively formed on the second surface. The first layer includes at least a part of a molecular structure of the molecules forming the source, which is a residue of the source. That is, the first layer includes at least a part of atoms forming the source.

At this step, at least a part of the molecular structure of the molecules forming the source may be adsorbed to a part of the first surface of the wafer 200, but an adsorption amount is slight, and an adsorption amount to the second surface of the wafer 200 is overwhelmingly larger. Such selective (preferential) adsorption becomes possible because, at step B, the state of the inhibitor adsorbed to the surface of the wafer 200 is effectively adjusted, and the film-formation inhibiting effect by the inhibitor remaining on the second surface is reduced or disabled while maintaining the film-formation inhibiting effect by the inhibitor remaining on the first surface.

After the first layer is selectively formed on the second surface of the wafer 200, the valve 243b is closed to stop supplying the source into the processing chamber 201. In a case where the catalyst is supplied together with the source, the valve 243d is closed to stop supplying the catalyst into the processing chamber 201. By the processing procedure and processing conditions similar to those in the purge at step A, the gaseous substance and the like remaining in the processing chamber 201 is removed from the inside of the processing chamber 201 (purge). The processing temperature when purging at this step is preferably similar to the processing temperature when supplying the source.

Processing conditions when supplying the source at step C1 are exemplified as follows:
processing temperature: 300 to 800 degrees C, preferably 400 to 650 degrees C,
processing pressure: 1 to 2,000 Pa, preferably 1 to 1,333 Pa,
processing time: 1 to 180 seconds, preferably 10 to 120 seconds,
source supply flow rate: 0.001 to 2 slm, preferably 0.01 to 1 slm, and
inert gas supply flow rate (per gas supply pipe): 0 to 20 slm.

The processing conditions when supplying the source and catalyst at step C1 are exemplified as follows:
processing temperature: room temperature (25 degrees C) to 200 degrees C, preferably 25 to 150 degrees C,
processing pressure: 13 to 2,666 Pa, preferably 13 to 1,333 Pa,
processing time: 1 to 90 seconds, preferably 1 to 60 seconds,
source supply flow rate: 0.001 to 2 slm, preferably 0.001 to 1 slm,
catalyst supply flow rate: 0.001 to 2 slm, preferably 0.001 to 1 slm, and
inert gas supply flow rate (per gas supply pipe): 0 to 20 slm.

As the source, for example, a silicon (Si)-containing substance source can be used.

As the source, for example, a substance containing Si and a chloro group (Cl), that is, chlorosilane such as monochlorosilane (SiH₃Cl), dichlorosilane (SiH₂Cl₂), trichlorosilane (SiHCl₃), tetrachlorosilane (SiCl₄), hexachlorodisilane (Si₂Cl₆), and octachlorotrisilane (Si₃Cl₈) can be used.

As the source, for example, a substance containing Si, a chloro group (Cl), and a hydrocarbon group, that is, alkylchlorosilane, alkylenechlorosilane and the like such as 1,1,3,3-tetrachloro-1,3-disilacyclobutane (C₂H₄Cl₄Si₂), 1,1,2,2-tetrachloro-1,2-dimethyldisilane ((CH₃)₂Si₂Cl₄), 1,2-dichloro-1,1,2,2-tetramethyldisilane (CH₃)₄Si₂Cl₂), bis(trichlorosilyl)methane ((SiCl₃)₂CH₂), and 1,2-bis(trichlorosilyl)ethane ((SiCl₃)₂C₂H₄) can be used.

For example, as the source, a substance containing Si and fluoro group (F), a substance containing Si and bromo group (Br), a substance containing Si and iodine group (I), that is, fluorosilane, bromosilane, iodine silane and the like such as tetrafluorosilane (SiF₄), difluorosilane (SiH₂F₂), tetrabromosilane (SiBr₄), dibromosilane (SiH₂Br₂), tetraiodosilane (SiI₄), and diiodosilane (SiH₂I₂) can be used. In addition, as the source, for example, a substance containing a siloxane bond and a chloro group (Cl) such as hexachlorodisiloxane (Cl₃Si-O-SiCl₃) and octachlorotrisiloxane (Cl₃Si-O-SiCl₂-O-SiCl₃) can also be used.

One or more of them can be used as the source.

As the catalyst, for example, a substance containing an amino group can be used.

As the catalyst, for example, cyclic amines such as pyridine (C₅H₅N), aminopyridine (C₅H₆N₂), picoline (C₆H₇N), lutidine (C₇H₉N), pyrimidine (C₄H₄N₂), quinoline (C₉H₇N), piperazine (C₄H₁₀N₂), piperidine (C₅H₁₁N), and aniline (C₆H₇N) can be used. As the catalyst, for example, chain amines such as triethylamine ((C₂H₅)₃N), diethylamine ((C₂H₅)₂NH), monoethylamine ((C₂H₅)NH₂), trimethylamine((CH₃)₃N), dimethylamine ((CH₃)₂NH), and monomethylamine ((CH₃)NH₂) can be used.

One or more of them can be used as the catalyst. The same applies to step C2 to be described later.

### [Step C2]

At this step, the wafer 200 is exposed to the reactant as the film-forming agent.

Specifically, the valve 243c is opened to allow the reactant to flow through the gas supply pipe 232c. The reactant, a flow rate of which is regulated by the MFC 241c, is supplied into the processing chamber 201 via the nozzle 249c, mixed in the processing chamber 201, and discharged from the exhaust port 231a. At that time, the reactant is supplied from the lateral side of the wafer 200 to the wafer 200, and the wafer 200 is exposed to the reactant (reactant supply, exposure). At that time, the valve 243d may be opened to cause the catalyst to flow through the gas supply pipe 232d, supply the wafer 200 with the reactant and the catalyst, and expose the wafer 200 to the reactant and the catalyst. At that time, the valves 243f to 243h may be opened to supply the inert gas into the processing chamber 201 via the nozzles 249a to 249c, respectively.

By exposing the wafer 200 to the reactant under the processing conditions to be described later, at least a part of the first layer formed on the second surface of the wafer 200 at step C1 can be reacted with the reactant to change the first layer to the second layer. In a case where the reactant contains, for example, a N-containing substance, at least a part of the first layer can be nitrided to change the first layer to a second layer containing Si and N, that is, a silicon nitride layer (SiN layer). In a case where the reactant contains, for example, an O-containing substance, at least a part of the first layer can be oxidized to change the first layer to a layer containing Si and O, that is, a silicon oxide layer (SiO layer). In a case where the reactant contains, for example, a N-containing substance and an O-containing substance, at least a part of the first layer can be nitrided or oxidized to change the first layer to a second layer containing Si, O, and N, that is, a silicon oxynitride layer (SiON layer). In a case where the above-described source is used, the SiN layer might further contain C or O, and the SiO layer or the SiON layer might further contain C. At that time, the first surface is covered with the inhibitor, and the reaction between the first surface and the reactant (nitridation or oxidation of the first surface) can be suppressed by the reaction suppressing effect of the inhibitor.

After the first layer formed on the second surface of the wafer 200 is changed to the second layer, the valve 243c is closed to stop supplying the reactant into the processing chamber 201. In a case where the catalyst is supplied together with the reactant, the valve 243d is closed to stop supplying the catalyst into the processing chamber 201. By the processing procedure and processing conditions similar to those in the purge at step A, the gaseous substance and the like remaining in the processing chamber 201 is removed from the inside of the processing chamber 201 (purge). The processing temperature when purging at this step is preferably similar to the processing temperature when supplying the reactant.

Processing conditions when supplying the reactant at step C2 are exemplified as follows:
processing temperature: 300 to 800 degrees C, preferably 400 to 650 degrees C,
processing pressure: 1 to 4,000 Pa, preferably 1 to 1,333 Pa,
processing time: 1 to 180 seconds, preferably 10 to 120 seconds,
reactant supply flow rate: 0.01 to 20 slm, preferably 0.01 to 10 slm, and
inert gas supply flow rate (per gas supply pipe): 0 to 20 slm.

The processing conditions when supplying the reactant and catalyst at step C2 are exemplified as follows:
processing temperature: room temperature (25 degrees C) to 200 degrees C, preferably 25 to 150 degrees C,
processing pressure: 13 to 2,666 Pa, preferably 13 to 1,333 Pa,
processing time: 1 to 90 seconds, preferably 1 to 60 seconds,
reactant supply flow rate: 0.001 to 2 slm, preferably 0.001 to 1 slm,
catalyst supply flow rate: 0.001 to 2 slm, preferably 0.001 to 1 slm, and
inert gas supply flow rate (per gas supply pipe): 0 to 20 slm.

As the reactant, for example, a N-containing substance, that is, a nitriding agent, an O-containing substance, that is, an oxidizing agent and the like can be used.

For example, as the reactant (nitriding agent), the N and H-containing substance, that is, hydrogen nitride such as NH₃, N₂H₂, N₂H₄, and N₃H₈ can be used, for example.

For example, as the reactant (oxidizing agent), the H and O-containing substance such as H₂O, H₂O₂, hydrogen (H₂)+O₂, H₂+O₃ and the like can be used. In this case, deuterium (D₂) can also be used instead of H₂.

Joint representation such as "H₂ + O₂" in the present specification means a mixture of H₂ and O₂. In a case of supplying the mixture, two substances may be mixed (premixed) in a supply pipe and then supplied into the processing chamber 201, or the two substances may be separately supplied into the processing chamber 201 from different supply pipes and mixed (post-mixed) in the processing chamber 201.

As the reactant (oxidizing agent), for example, the O-containing substance such as O₂, O₃, nitrous oxide (N₂O), nitrogen monoxide (NO), nitrogen dioxide (NO₂), carbon monoxide (CO), and carbon dioxide (CO₂) can be used.

One or more of them can be used as the reactant.

As the catalyst, for example, the substance similar to the various catalysts exemplified at step C1 described above can be used.

### [Perform Predetermined Number of Times]

By performing a cycle including the above-described steps C1 and C2 a predetermined number of times (n times, n is 1 or an integer equal to or larger than 2), a film can be formed on the second surface as illustrated in FIG. 4D. By using the above-described Si-containing substance as the source and the above-described nitriding agent as the reactant, a silicon nitride film (SiN film), a silicon carbonitride film (SiCN film), a silicon oxynitride film (SiON film) and the like can be formed on the second surface. By using the above-described Si-containing substance as the source and the above-described oxidizing agent as the reactant, a silicon oxide film (SiO film), a silicon oxycarbide film (SiOC film) and the like can be formed on the second surface. By using the above-described Si-containing substance as the source and the above-described nitriding agent or oxidizing agent as the reactant, a silicon oxynitride film (SiON film), a silicon oxycarbonitride film (SiOCN film) and the like can be formed on the second surface. The cycle described above is preferably repeated a plurality of times. That is, it is preferable to make a thickness of the second layer formed per cycle smaller than a desired film thickness and repeat the above-described cycle a plurality of times until a thickness of the film formed by stacking the second layer reaches a desired thickness. In a case where the above-described cycle is repeated a plurality of times, the first surface is covered with the inhibitor, and the film formation on the first surface can be suppressed by the film-formation inhibiting effect by the inhibitor.

### (After-Purge and Atmospheric Pressure Restoration)

After step C is finished, the inert gas as the purge gas is supplied from each of the nozzles 249a to 249c into the processing chamber 201 and is discharged from the exhaust port 231a. Therefore, the inside of the processing chamber 201 is purged, and a gas, a reaction by-product and the like remaining in the processing chamber 201 are removed from the inside of the processing chamber 201 (after-purge). Thereafter, the atmosphere in the processing chamber 201 is replaced with the inert gas (inert gas replacement), so that the pressure in the processing chamber 201 is restored to a normal pressure (atmospheric pressure restoration).

### (Boat Unload and Wafer Discharge)

After that, the boat elevator 115 lowers the seal cap 219, and the lower end of the manifold 209 is opened. Then, the processed wafer 200 is unloaded from the lower end of the manifold 209 to the outside of the reaction tube 203 in a state of being supported by the boat 217 (boat unload). After the boat unload, the shutter 219s is moved, and the lower end opening of the manifold 209 is sealed with the shutter 219s via the O-ring 220c (shutter close). After being unloaded to the outside of the reaction tube 203, the processed wafer 200 is taken out from the boat 217 (wafer discharge).

Steps A to C are preferably performed in the same processing chamber (in-situ). When a series of processing is performed in-situ, the wafer 200 is not exposed to the atmosphere in the middle, and the processing can be consistently performed while the wafer 200 is placed under vacuum, and stable processing can be performed.

### (3) Effects by Present Embodiment

According to the present embodiment, one or a plurality of effects described below can be obtained.
(a) At step B, the substrate with the inhibitor adsorbed to the first surface and the second surface is exposed to the processing agent to remove a part of the inhibitor adsorbed to the first surface and a part of the inhibitor adsorbed to the second surface. That is, at step B, removal of a part of the inhibitor adsorbed to the first surface and removal of a part of the inhibitor adsorbed to the second surface are allowed, instead of selectively removing the inhibitor adsorbed to the second surface. As a result, at step **B,** restriction of the processing conditions when removing the inhibitor can be alleviated, and the processing conditions can have a degree of freedom.

By giving a degree of freedom to the processing conditions at step **B,** at step **B,** the processing temperature when removing a part of the inhibitor can be set to the same temperature as the processing temperature at the step performed before and/or after the step. As a result, a standby time required for temperature regulation becomes unnecessary, and a reduction in productivity in the entire processing can be avoided.

By giving a degree of freedom to the processing conditions at step B, at step B, the inhibitor having a weak adsorption power on the first surface can be removed (eliminated) in advance from the first surface before performing step C. This makes it possible to reduce an amount of inhibitor desorbed from the first surface while performing step C, and as a result, to reduce an amount of impurities caused by the inhibitor contained in the film formed at step C.

By giving a degree of freedom to the processing conditions at step B, at step B, the removal of the inhibitor adsorbed to the second surface can be performed softly while suppressing damage to the second surface. As a result, the state of the second surface after step B is performed can be appropriately maintained, and interface characteristics between the film formed on the second surface at step C and the second surface can be improved.

By giving a degree of freedom to the processing conditions at step B, at step B, an adsorption power of the inhibitor adsorbed to the first surface can be appropriately reduced. As a result, after performing step C, it might be unnecessary to perform a reset step for removing the inhibitor remaining on the first surface. Even in a case where the reset step is performed, this can be performed in a short time. As a result, it is possible to avoid a reduction in productivity in the entire processing.

(b) At step B, the state of the inhibitor adsorbed to each of the first surface and the second surface can be effectively adjusted. That is, at step B, the inhibitor adsorbed to the second surface is not selectively removed, but it becomes possible to reduce or disable the film-formation inhibiting effect by the inhibitor remaining on the second surface while maintaining the film-formation inhibiting effect by the inhibitor allowed to remain on the first surface while allowing removal of a part of the inhibitor adsorbed to the first surface and removal of a part of the inhibitor adsorbed to the second surface.

As a result, at step C, the incubation time on the second surface can be shortened or eliminated while prolonging the incubation time on the first surface, and selective film formation on the second surface becomes possible. Furthermore, at step C, in-plane film thickness uniformity of the film formed on the second surface can be improved, surface roughness can be improved, and the productivity of the processing can be improved. The surface roughness means a difference in height of the surface of the film in a substrate plane or any target plane, and the smaller the value, the smoother the surface. In the present specification, when the surface roughness is improved (becomes excellent), this means that the difference in height of the surface of the film is reduced and the smoothness is improved (becomes excellent).

(c) Since the processing agent used at step B contains at least one selected from the group of the N-containing substance, H-containing substance, O-containing substance, F-containing substance, and Cl-containing substance, at step B, it is possible to effectively maintain the film-formation inhibiting effect by the inhibitor remaining on the first surface and to reduce or disable the film-formation inhibiting effect by the inhibitor remaining on the second surface.

Since the processing agent used at step B contains at least one selected from the group of the N and H-containing substance, H and O-containing substance, H and F-containing substance, N and F-containing substance, Cl and F-containing substance, F, N, and O-containing substance, H and Cl-containing substance, and Cl and Si-containing substance, at step B, it is possible to more effectively maintain the film-formation inhibiting effect by the inhibitor remaining on the first surface and to reduce or disable the film-formation inhibiting effect by the inhibitor remaining on the second surface.

Since the processing agent used at step B contains the H and O-containing substance, for example, contains H₂O or H₂O₂, at step B, it is possible to more effectively maintain the film-formation inhibiting effect by the inhibitor remaining on the first surface and to reduce or disable the film-formation inhibiting effect by the inhibitor remaining on the second surface.

(d) Since the first surface contains an oxide and the second surface contains a material different from this oxide, at step B, it is possible to effectively maintain the film-formation inhibiting effect by the inhibitor remaining on the first surface and to reduce or disable the film-formation inhibiting effect by the inhibitor remaining on the second surface.

Since the oxygen concentration on the first surface is higher than the oxygen concentration on the second surface, that is, the density of the OH groups terminating at the first surface is higher than the density of the OH groups terminating at the second surface, at step B, it is possible to more effectively maintain the film-formation inhibiting effect by the inhibitor remaining on the first surface and to reduce or disable the film-formation inhibiting effect by the inhibitor remaining on the second surface.

Since the first surface contains Si, and the second surface contains at least one selected from the group of Si and metal, or is Si-free, at step B, it is possible to more effectively maintain the film-formation inhibiting effect by the inhibitor remaining on the first surface and to reduce or disable the film-formation inhibiting effect by the inhibitor remaining on the second surface.

(e) At step A, the substrate including the first surface and the second surface is exposed to the modifier, so that the inhibitor contained in the modifier is adsorbed to each of the first surface and the second surface. That is, at step A, adsorption of the inhibitor to the first surface and adsorption of the inhibitor to the second surface are allowed, instead of selectively allowing the inhibitor to adsorb to the first surface. As a result, at step A, restriction of the processing conditions when allowing the inhibitor to adsorb can be alleviated, and the processing conditions can have a degree of freedom.

By giving a degree of freedom to the processing conditions at step A, at step A, the processing temperature when allowing the inhibitor to adsorb can be set to the same temperature as the processing temperature at the step performed before and/or after the step. As a result, a standby time required for temperature regulation becomes unnecessary, and a reduction in productivity in the entire processing can be avoided.

(f) Since step A is performed under at least one selected from the group of the following conditions: a condition that an amount of the inhibitor to be adsorbed to the first surface is larger than an amount of the inhibitor to be adsorbed to the second surface, a condition that density of the inhibitor to be adsorbed to the first surface is higher than density of the inhibitor to be adsorbed to the second surface, and a condition that coverage of the first surface by the inhibitor to be adsorbed to the first surface is higher than coverage of the second surface by the inhibitor to be adsorbed to the second surface, at step B, it is possible to effectively maintain the film-formation inhibiting effect by the inhibitor remaining on the first surface and to reduce or disable the film-formation inhibiting effect by the inhibitor remaining on the second surface.

By performing step A under the condition that the continuous layer is formed by the inhibitor to be adsorbed to the first surface and the discontinuous layer is formed by the inhibitor to be adsorbed to the second surface, at step B, it is possible to effectively maintain the film-formation inhibiting effect by the inhibitor remaining on the first surface and to reduce or disable the film-formation inhibiting effect by the inhibitor remaining on the second surface.

(g) At step B, by setting the amount by which the inhibitor adsorbed to the first surface is removed to be equal to or larger than the amount by which the inhibitor adsorbed to the second surface is removed, it is possible to further alleviate the restriction of the processing conditions at step B and to give a wider degree of freedom to the processing conditions at step B. This makes it possible to more effectively obtain the above-described effect obtained by giving a degree of freedom to the processing conditions at step B.

At step B, the amount by which the inhibitor adsorbed to the first surface is removed is made larger than the amount by which the inhibitor adsorbed to the second surface is removed, so that the restriction of the processing conditions at step B can be further alleviated, and a wider degree of freedom can be given to the processing conditions at step B. This makes it possible to further effectively obtain the above-described effect obtained by giving a degree of freedom to the processing conditions at step B.

(h) At step C, by exposing the substrate, which has been exposed to the processing agent, to the film-forming agent, it is possible to selectively form a film on the second surface while suppressing formation of a film on the first surface.

(i) The above-described effects can be similarly obtained even in a case where a predetermined substance is optionally selected from the various modifiers, various processing agents, various film-forming agents, and various inert gases described above to be used.

### <Other Embodiments of Present Disclosure>

The embodiment of the present disclosure has been specifically described above. Note that, the present disclosure is not limited to the embodiment described above, and can be variously modified without departing from the gist thereof.

For example, the exposure of the substrate to the processing agent at step B is not limited to a case where the exposure is performed by supplying a gaseous processing agent to the substrate. For example, the exposure of the substrate to the processing agent may be performed by exposing the substrate to the atmosphere, or may be performed, for example, by exposing the substrate to a liquid processing agent, for example, by immersing the substrate in a liquid processing agent. That is, step B and steps A and C may be performed in different spaces (ex-situ).

The processing conditions when exposing the substrate to the atmosphere at step B are exemplified as follows:
processing temperature: room temperature (25 degrees C),
processing pressure: atmospheric pressure, and
processing time: 1 to 600,000 seconds, preferably 600 to 43,200 seconds.

The processing conditions when exposing the substrate to the liquid processing agent at step B are exemplified as follows:
processing time: 1 to 600 seconds, preferably 1 to 120 seconds.

As the liquid processing agent, for example, water, pure water, ultrapure water and the like can be used. The pure water and the ultrapure water include RO water, deionized water, distilled water and the like.

Even in these embodiments, effects similar to those in the embodiment described above can be obtained.

For example, timing of performing steps A to C is not limited to the case of sequentially performing steps without overlapping with each other as in the above-described embodiment. For example, as illustrated in FIG. 5B, after step A is performed, step B may be performed at least partially overlapping with step C. For example, as illustrated in FIG. 5C, after step A is performed, step B may be performed so as to overlap with an initial stage of step C. That is, when steps A to C are performed, an overlapping period T in which step B and step C are performed in parallel may be provided. In these cases, the film-forming agent contains a processing agent. Specifically, the film-forming agent supplied in the overlapping period T, that is, at least selected from the group of the source and the reactant acts as the processing agent. In addition to at least one selected from the group of the source and the reactant, the catalyst might act as the processing agent. The catalyst might promote the action as the processing agent of at least one selected from the group of the source and the reactant.

Processing conditions when supplying the source at step C1 in the overlapping period T are exemplified as follows:
processing temperature: 300 to 800 degrees C, preferably 400 to 650 degrees C,
processing pressure: 1 to 3,000 Pa, preferably 1 to 2,000 Pa,
processing time: 30 to 600 seconds, preferably 60 to 300 seconds,
source supply flow rate: 0.001 to 3 slm, preferably 0.01 to 2 slm, and
inert gas supply flow rate (per gas supply pipe): 0 to 20 slm.

Processing conditions when supplying the reactant at step C2 in the overlapping period T are exemplified as follows:
processing temperature: 300 to 800 degrees C, preferably 400 to 650 degrees C,
processing pressure: 1 to 4,000 Pa, preferably 1 to 1,333 Pa,
processing time: 30 to 600 seconds, preferably 60 to 300 seconds,
reactant supply flow rate: 0.01 to 30 slm, preferably 0.01 to 20 slm, and
inert gas supply flow rate (per gas supply pipe): 0 to 20 slm.

The processing conditions at steps C1 and C2 after the overlapping period T is finished can be similar to the processing conditions at steps C1 and C2 in the above-described embodiment, respectively.

The processing conditions when supplying the source and catalyst at step C1 in the overlapping period T are exemplified as follows:
processing temperature: room temperature (25 degrees C) to 200 degrees C, preferably 25 to 150 degrees C,
processing pressure: 133 to 2,666 Pa,
processing time: 30 to 600 seconds, preferably 60 to 300 seconds,
source supply flow rate: 0.1 to 3 slm,
catalyst supply flow rate: 0.1 to 3 slm, and
inert gas supply flow rate (per gas supply pipe): 0 to 20 slm.

The processing conditions when supplying the reactant and catalyst at step C2 in the overlapping period T are exemplified as follows:
processing temperature: room temperature (25 degrees C) to 200 degrees C, preferably 25 to 150 degrees C,
processing pressure: 133 to 2,666 Pa,
processing time: 30 to 600 seconds, preferably 60 to 300 seconds,
reactant supply flow rate: 0.1 to 3 slm,
catalyst supply flow rate: 0.1 to 3 slm, and
inert gas supply flow rate (per gas supply pipe): 0 to 20 slm.

The processing conditions at steps C1 and C2 after the overlapping period T is finished can be similar to the processing conditions at steps C1 and C2 in the above-described embodiment, respectively.

Other processing procedures and processing conditions can be similar to the processing procedures and the processing conditions in the embodiment described above, for example.

Even in each embodiment illustrated in FIG. 5B and 5C, effects similar to those in the embodiment described above can be obtained.

According to these embodiments, by providing the overlapping period T in which step B and step C are performed in parallel, it is possible to shorten the processing time of entire steps B and C and improve the productivity of the entire processing.

Preferably, a recipe used in each processing is individually prepared according to processing contents and is recorded and stored in the memory 121c via an electric communication line or the external memory 123. When each processing is started, the CPU 121a preferably appropriately selects an appropriate recipe from among a plurality of recipes recorded and stored in the memory 121c according to the processing contents. Therefore, it is possible to perform the various pieces of processing on films with various film types, composition ratios, film qualities, and film thicknesses with excellent reproducibility by using the processing apparatus. It is possible to reduce a burden on an operator, and to quickly start each processing while avoiding an operation error.

The recipe described above is not limited to a newly created recipe, but may be prepared by, for example, changing the existing recipe already installed in the processing apparatus. In a case of changing the recipe, the changed recipe may be installed in the processing apparatus via an electric communication line or a recording medium in which the recipe is recorded. The existing recipe already installed in the processing apparatus may be directly changed by operating the input/output device 122 included in the existing processing apparatus.

In the embodiments described above, an example has been described in which the processing is performed by using a batch-type processing apparatus that processes a plurality of substrates at a time. The present disclosure is not limited to the embodiments described above, and can be applied to a case of performing the processing by using a single wafer type processing apparatus that processes one or more substrates at a time, for example. In the embodiments described above, an example of performing the processing using the processing apparatus including a hot wall type processing furnace has been described. The present disclosure is not limited to the embodiments described above, and can be applied to a case of performing the processing by using a processing apparatus including a cold wall type processing furnace.

In the embodiments described above, an example has been described in which the above-described processing sequence is performed in the same processing chamber of the same processing apparatus (in-situ). The present disclosure is not limited to the embodiments described above, and for example, any step and any other step of the above-described processing sequence may be performed in different processing chambers of different processing apparatuses (ex-situ), or may be performed in different processing chambers of the same processing apparatus.

Even in a case where such processing apparatuses are used, each processing can be performed in accordance with processing procedures and processing conditions similar to those in the embodiments and variations described above, so that effects similar to those in the embodiments and variations described above can be obtained.

The embodiments described above and variations can be used in combination as appropriate. The processing procedures and processing conditions at that time can be similar to the processing procedures and processing conditions in the embodiments and variations described above, for example.

According to the present disclosure, it becomes possible to effectively adjust a state of an inhibitor adsorbed to a surface of a substrate.

## Claims

1. A processing method comprising:
(a) providing a substrate including a first surface and a second surface with an inhibitor adsorbed to the first surface and the second surface; and
(b) removing a part of the inhibitor adsorbed to the first surface and a part of the inhibitor adsorbed to the second surface by exposing the substrate to a processing agent to reduce or disable a film-formation inhibiting effect by the inhibitor remaining on the second surface while maintaining the film-formation inhibiting effect by the inhibitor remaining on the first surface.

2. The processing method according to Claim 1, wherein
the processing agent used in (b) includes at least one selected from the group of a nitrogen-containing substance, a hydrogen-containing substance, an oxygen-containing substance, a fluorine-containing substance, and a chlorine-containing substance.

3. The processing method according to Claim 1 to 2, wherein
the first surface contains an oxide, and the second surface contains a material different from the oxide.

4. The processing method according to any one of Claims 1 to 3, wherein
oxygen concentration of the first surface is higher than oxygen concentration of the second surface.

5. The processing method according to any one of Claims 1 to 4, wherein
the first surface contains silicon, and the second surface contains at least one selected from the group of silicon and metal, or is silicon-free.

6. The processing method according to any one of Claims 1 to 5, wherein
in (a), by exposing the substrate to a modifier, the inhibitor contained in the modifier is adsorbed to the first surface and the second surface.

7. The processing method according to any one of Claims 1 to 6, wherein
(a) is performed under at least one selected from the group of the following conditions:
a condition that an amount of the inhibitor to be adsorbed to the first surface is larger than an amount of the inhibitor to be adsorbed to the second surface;
a condition that density of the inhibitor to be adsorbed to the first surface is higher than density of the inhibitor to be adsorbed to the second surface; and
a condition that coverage of the first surface by the inhibitor to be adsorbed to the first surface is higher than coverage of the second surface by the inhibitor to be adsorbed to the second surface.

8. The processing method according to any one of Claims 1 to 7, wherein
in (b), an amount by which the inhibitor adsorbed to the first surface is removed is equal to or more than an amount by which the inhibitor adsorbed to the second surface is removed.

9. The processing method according to any one of Claims 1 to 7, wherein
in (b), an amount by which the inhibitor adsorbed to the first surface is removed is more than an amount by which the inhibitor adsorbed to the second surface is removed.

10. The processing method according to any one of Claims 1 to 9, further comprising:
(c) forming a film on the second surface by exposing the substrate, which has been exposed to the processing agent, to a film-forming agent.

11. The processing method according to Claim 10, wherein
the film-forming agent contains the processing agent, and
(b) is performed at least partially overlapping with (c).

12. The processing method according to Claim 10, wherein
the film-forming agent contains the processing agent, and
(b) is performed at an initial stage of (c).

13. A method of manufacturing a semiconductor device, comprising the processing method of Claim 1.

14. A processing apparatus comprising:
a provider configured to provide a substrate;
a processing agent exposure system configured to expose the substrate to a processing agent; and
a controller configured to be capable of controlling the provider and the processing agent exposure system to perform a process including:
(a) providing a substrate including a first surface and a second surface with an inhibitor adsorbed to the first surface and the second surface; and
(b) removing a part of the inhibitor adsorbed to the first surface and a part of the inhibitor adsorbed to the second surface by exposing the substrate to the processing agent to reduce or disable a film-formation inhibiting effect by the inhibitor remaining on the second surface while maintaining the film-formation inhibiting effect by the inhibitor remaining on the first surface.

15. A program that causes, by a computer, a processing apparatus to perform a process comprising:
(a) providing a substrate including a first surface and a second surface with an inhibitor adsorbed to the first surface and the second surface; and
(b) removing a part of the inhibitor adsorbed to the first surface and a part of the inhibitor adsorbed to the second surface by exposing the substrate to a processing agent to reduce or disable a film-formation inhibiting effect by the inhibitor remaining on the second surface while maintaining the film-formation inhibiting effect by the inhibitor remaining on the first surface.
